# EUROPÄISCHE PATENTSCHRIFT

(11) **EP 0 775 400 B1**
(45) Veröffentlichungstag und Bekanntmachung des Hinweises auf die Patenterteilung: **22.03.2000**
(21) Anmeldenummer: 95927644.5
(22) Anmeldetag: 08.08.1995
(51) Int. Cl.: H04L 7/033, H03L 7/081

(54) **INTEGRIERBARE TAKTGEWINNUNGSSCHALTUNG**
INTEGRABLE CLOCK RECOVERY CIRCUIT
CIRCUIT D'EXTRACTION DE SIGNAL D'HORLOGE POUVANT ETRE INTEGRE

(30) Priorität: 08.08.1994 DE 4427972
(43) Veröffentlichungstag der Anmeldung: 28.05.1997
(73) Patentinhaber: SIEMENS AKTIENGESELLSCHAFT, 80333 München (DE)
(72) Erfinder: TRUMPP, Gerhard, D-82178 Puchheim (DE)
(86) Internationale Anmeldenummer: DE9501038
(87) Internationale Veröffentlichungsnummer: WO9605672

(56) Entgegenhaltungen:
- EP-A- 0 418 641
- EP-A- 0 460 274
- AU-B- 604 997
- PATENT ABSTRACTS OF JAPAN vol. 008 no. 149 (E-255) ,12.Juli 1984 & JP,A,59 054344 (FUJI DENKI SEIZO KK;OTHERS: 01) 29.März 1984,

## Beschreibung

Die Erfindung betrifft ein Verfahren und eine Schaltungsanordnung zur Gewinnung eines Taktsignales.

In digitalen Datenübertragungssystemen kann der Bittakt empfängerseitig durch Taktrückgewinnungsschaltungen aus dem empfangenen digitalen Datensignal gewonnen werden. Bei Phasenregelkreisen (Phase locked Loop) zur Taktrückgewinnung aus einem digitalen Datenstrom kommen nur reine Phasenvergleicher (phasensensitive Phasendetektoren) in Betracht, da nicht mit jedem Bittakt eine Phasenkorrektur-Flanke zur Verfügung steht, sondern, in Abhängigkeit von der vorgesehenen Codierung, beispielsweise im Mittel nur alle drei Bittakte. Diese reinen Phasenvergleicher haben bekanntermaßen den Nachteil, daß damit aufgebaute Schaltungen auch auf harmonische Frequenzen verriegeln oder dies auch auf anderen Frequenzen (erfolglos) versuchen. Um diese Nachteile zu vermeiden, wurden bislang spannungsgesteuerte Oszillatoren mit jeweils genau definierter Mittenfrequenz, die dem Nominalwert des Bittaktes entspricht, und sehr kleinem Frequenzhub eingesetzt, wobei zur Realisierung solcher spannungsgesteuerter Oszillatoren genaue frequenzbestimmende Elemente benötigt werden (vgl. Unterrichtsblätter der Deutschen Bundespost, Jahrgang 34/1981, Nr. 2, Seite 81).

In digitalen Datenübertragungsnetzen, wie z.B. in SDH(Synchron Digital Hierarchy)-Übertragungssystemen werden zur Sendetakterzeugung PLL(Phase Locked Loop) - Schaltungen verwendet. Der Phasenregelkreis vergleicht den Füllstand eines Pufferspeichers mit seinem Sollwert und korrigiert entsprechend die Sendefrequenz. Die nominale Sendefrequenz liegt fest, sie ist durch die Mittenfrequenz des Phasenregelkreises definiert. Die tatsächliche Sendefrequenz wird durch Ziehen des Phasenregelkreises über seine Steuerspannung aufgrund der anfallenden Datenmenge bestimmt. Das Signal, das die Abweichung des Füllstandes des Pufferspeichers vom Sollwert angibt, ist durch ein diskretes Signal mit einer im Vergleich zur Sendefrequenz niedrigen Rate von Zustandswechseln gegeben. An sich bekannte, integrierte spannungsgesteuerte Oszillatoren VCOs (Voltage Controlled Oscillator) sind bei dieser Anwendung aufgrund der seltenen Korrektur nicht einsetzbar, da ihre Kurzzeitstabilität im Hinblick auf die Genauigkeitsanforderungen für synchrone Datennetze bei weitem nicht ausreicht.

Auch bei dieser Anwendung kommen üblicherweise Schaltungen zum Einsatz, bei denen ein Phasenregelkreis einen spannungsgesteuerten, quarzstabilisierten Oszillator VCXO (Voltage Controlled Xtal (=crystal) Oscillator) regelt. Diese spannungsgesteuerten, quarzstabilisierten Oszillatoren benötigen genaue frequenzbestimmende Elemente zur Stabilisierung.

Die genannten, frequenzbestimmenden Elemente, die durch schmalbandige Filter oder Schwingkreise gegeben sein können und die beispielsweise mit Oberflächenwellen-, Quarz- oder Keramikfiltern realisiert sein können, sind nicht ohne weiteres zusammen mit der übrigen Schaltung in einem Baustein integrierbar, so daß die frequenzbestimmenden Elemente außerhalb des Bausteins angeordnet werden müssen, wozu zusätzliche Anschlüsse an den Baustein vorgesehen werden müssen, zusätzlicher Platzbedarf auf der Baugruppe benötigt wird und ein erhöhter Aufwand bei der Bestückung der Baugruppe notwendig ist.

In digitalen Übertragungssystemen, in denen gleichzeitig eine Mehrzahl von Datensignalen, die nicht phasenstarr zueinander sind, empfangen oder ausgesendet werden sollen, macht sich der Aufwand besonders störend bemerkbar, daß für jedes Datensignal ein gesonderter Phasenregelkreis mit jeweiligen genauen frequenzbestimmenden Elementen vorgesehen werden muß.

Der Erfindung liegt das Problem zugrunde ein Verfahren und eine Schaltungsanordnung zur Gewinnung eines Taktsignales anzugeben, bei denen präzise externe oder abzugleichende frequenzbestimmende Elemente vermieden sind.

Die wesentlichen Merkmale zur Lösung des Problems sind dadurch gegeben, daß
- mehrere jeweils eine gesteuerte Verzögerungsleitung (VCD0, VCD1), einen Phasenvergleicher (PV0, PV1) und einen Schleifenfilter (LF0, LF1) aufweisende Phasenregler (PR0, PR1) gegeben sind, deren Steuerspannungen in einem Regelbereich zwischen einer oberen (UH) und einer unteren (UL) Grenze aussteuerbar sind
- den Eingängen der Verzögerungsleitungen der Phasenregler ein Referenztaktsignal (CREF0, CREF1) zugeführt ist
- ein Phasenregler ausgewählt ist, dessen ausgangsseitig abgegebenes Signal als das Taktsignal gegeben ist
- die Verzögerungsdauer des ausgewählten Phasenreglers nach Maßgabe eines Ansteuersignales beeinflußt ist
- bei Aussteuerung an die obere oder die untere Grenze des Regelbereiches des gerade ausgewählten Phasenreglers ein jeweiliger anderer Phasenregler auswählbar ist, dessen Steuerspannung gerade nicht an dieser Grenze ausgesteuert ist.

Der Anmeldungsgegenstand ist in einem integrierten Baustein vollständig implementierbar. Der Anmeldungsgegenstand vermeidet schwerlich integrierbare, präzise frequenzbestimmende Bauelemente, wodurch der Aufwand für die frequenzbestimmenden Bauelemente selbst, der Aufwand für die ansonsten zusätzlich vorzusehenden Anschlüsse des integrierten Bausteins, der Aufwand für den Einbauplatz der frequenzbestimmenden Bauelemente auf der Baugruppe und der Aufwand für die ansonsten notwendige Bestückung der Baugruppe mit den frequenzbestimmenden Bauelementen erspart ist. Der Anmeldungsgegenstand ist herkömmlichen Taktgewinnungseinrichtungen prinzipiell überlegen, wenn er ein ohnehin lokal vorhandenes Sendetaktsignal als Referenztaktsignal ausnutzt, da ein Sendetaktsignal in der Regel erheblich stabiler bezüglich der Einhaltung der Frequenz ist als das von einem spannungsgesteuerten Oszillator (Voltage Controlled Oszillator) abgegebene Taktsignal, womit das von der anmeldungsgemäßen Taktrückgewinnungseinrichtung abgegebene Taktsignal CLKOUT insgesamt frequenzstabiler ist.

Im Anwendungsfall einer Taktrückgewinnung aus einem Datenstrom mit langen Folgen gleicher Binärzeichen mit einer herkömmlichen Taktrückgewinnungseinrichtung können Frequenzabweichungen des spannungsgesteuerten Oszillators sich zu beliebigen Phasendifferenzen aufintegrieren; bei der anmeldungsgemäßen Taktgewinnungseinrichtung führt in diesem Fall eine aufgrund von Leckstom des als Schleifenfilter ausgebildeten Kondensators bedingte Änderung der Steuerspannung zu einer Phasendifferenz, die auf maximal 180 Grad bezüglich des Referenztaktsignals begrenzt ist.

Die Erfindung wird nun als Ausführungsbeispiel in einem zum Verständnis erforderlichen Umfang anhand von Figuren näher beschrieben.

Dabei zeigen:
Fig 1 ein Blockschaltbild der erfindungsgemäßen Taktgewinnungsschaltung für eine Taktrückgewinnung aus einem Datensignal
Fig 2a, 2b nähere Einzelheiten der Taktgewinnungsschaltung aus Fig 1
Fig 3 und Fig 4 typische Signalverläufe in der Taktgewinnungsschaltung für Verhältnisse größer 1 bzw. kleiner 1 des Referenztaktsignals zu dem im Datenstrom enthaltenen Taktsignal.
Fig 5 ein Blockschaltbild der erfindungsgemäßen Schaltungsanordnung für eine Taktgewinnung zur Aussendung eines Datensignales,
Fig 6 ein Prinzipschaltbild des Blockschaltbildes aus Fig 5,
Fig 7 a, b nähere Einzelheiten der Schaltung aus Fig 6.

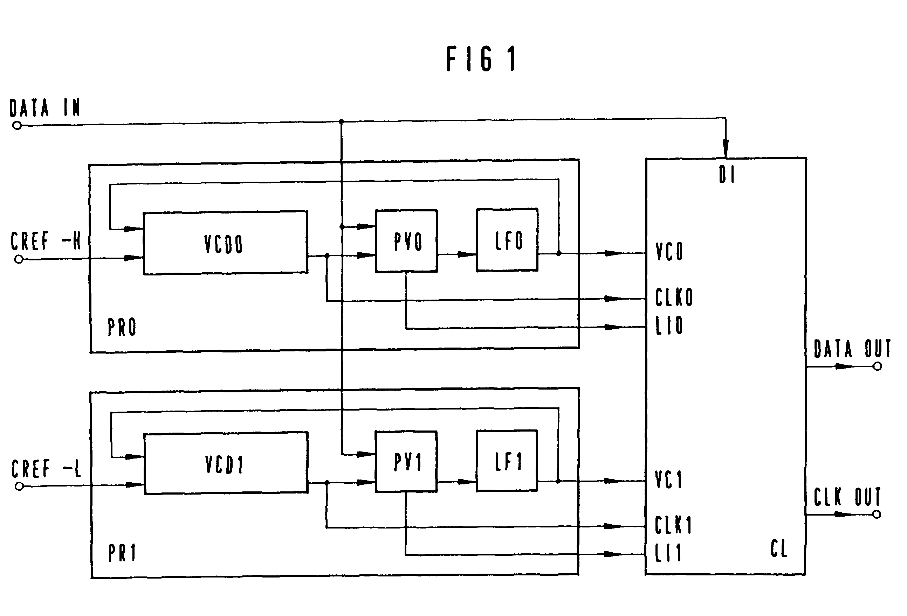

Die Blockschaltung in Fig 1 weist zwei Phasenregler PR0, PR1 und eine Kontrolleinheit CL (für: Control-Logic) auf. Den Phasenreglern und der Kontrolleinheit werden über eine Anschlußklemme DATAIN ein serieller Datenstrom als Eingangssignal zugeführt. Bei dem Datenstrom möge es sich um Binärzeichen mit einer vorgegebenen nominellen Folgerate handeln. Als weiteres Eingangssignal wird den Phasenreglern ein Referenztaktsignal CREF zugeführt, das annähernd die dem Datenstrom zugehörige Taktfrequenz aufweist. Das Referenztaktsignal möge durch ein lokal ohnehin vorhandenes Taktsignal gegeben sein, das zur Aussendung eines Datenstromes benötigt wird. In einer bevorzugten Ausführungsform werden den Phasenreglern jeweils zueinander komplementäre Referenztaktsignale CREF_H, CREF_L zugeführt. In einem Phasenregler wird das betreffende Referenztaktsignal einer spannungsgesteuerten Verzögerungsleitung VCD0, VCD1 zugeführt. In der Verzögerungsleitung wird das Referenztaktsignal nach Maßgabe einer zugeführten Steuerspannung VC0, VC1 verzögert. Das von der Verzögerungsleitung abgegebene Referenztaktsignal und der Datenstrom werden einem Phasenvergleicher PV0, PV1 als Eingangssignale zugeführt. Der Phasenvergleicher liefert nach Maßgabe der Koinzidenz der ihm zugeführten Eingangssignale ein Ausgangssignal, das einem Schleifenfilter LF0, LF1 zugeführt wird. In dem Schleifenfilter erfährt dieses Ausgangssignal eine an sich für Phasenregelkreise (Phase-locked-loop) bekannte Behandlung mit integrierender Wirkung. Das von dem Schleifenfilter abgegebene Ausgangssignal wird einerseits der Verzögerungsleitung als Steuerspannung und andererseits der Kontrolleinheit an deren Klemme VC0, VC1 zugeführt. Neben dem Ausgangssignal an Klemme VC0, VC1 führt jeder Phasenregler der Kontrolleinheit an der Klemme CLK0, CLK1 das von der zugehörigen Verzögerungsleitung verzögerte Referenztaktsignal sowie an der Klemme LI0, LI1 ein von dem Phasenvergleicher geliefertes Informationssignal zu. Dieses Informationssignal ist nach Maßgabe der Phasenabweichung zwischen den dem Phasenvergleicher zugeführten Signalen gebildet. Die Kontrolleinheit gibt unter Auswertung der ihr eingangsseitig zugeführten Signale an der Klemme DATAOUT den Datenstrom und an der Klemme CLKOUT das mit diesem Datenstrom korrelierte Taktsignal ab. Das an der Klemme CLKOUT abgegebene Taktsignal kann also gegenüber dem Referenztaktsignal dauerhaft eine etwas höhere oder eine etwas niedrigere Frequenz aufweisen. Zum Ausgleich der Frequenzdifferenz zwischen dem Referenztaktsignal und dem Taktsignal CLKOUT wird das Referenztaktsignal in einer Verzögerungsleitung zunehmend phasenverschoben.

Jeder der Phasenregler vermag auf den der Klemme DATAIN zugeführten Datenstrom einzurasten und Phasendifferenzen zwischen dem Referenztaktsignal und dem Datenstrom durch geeignete Nachführung der Verzögerungszeit der Verzögerungsleitung auszugleichen, bis die Verzögerungsleitung die Grenze ihres Regelbereichs erreicht. Die Kontrolleinheit hat die Aufgabe stets einen Phasenregler auszuwählen, der innerhalb seines Regelbereiches arbeitet, und gleichzeitig einen gerade nicht ausgewählten Phasenregler in einer derartigen Einstellung seines Regelbereiches bereitzuhalten, daß er dann übernehmen kann, wenn der gerade ausgewählte Phasenregler die Grenze seines Regelbereiches erreicht. Für die Auswahl eines Phasenreglers einerseits und die Bereithaltung eines gerade nicht ausgewählten Phasenreglers im Zustand einer geeigneten Einstellung seines Regelbereichs andererseits wertet die Kontrolleinheit die Steuerspannungen VC0, VC1 für die Verzögerungsleitungen und ergänzend hierzu gegebenenfalls die von den Phasenvergleichern abgegebenen Informationssignale aus. Die Kontrolleinheit weist einen Taktmultiplexer auf, der eines von der Kontrolleinheit an den Klemmen CLK0, CLK1 zugeführten Taktsignalen auf die Klemme CLKOUT durchschaltet. Je nach Art des zum Einsatz kommenden Phasenvergleichers weist die Kontrolleinheit ein Abtast - Flipflop zur Abtastung des Datensignales mit dem zurückgewonnenen Taktsignal auf; bei Einsatz eines aus der Literaturstelle T. H. LEE , J.F.Bulzacchelli, "A 155-MHz Clock Recovery Delay- and Phase-Locked loop", IEEE J. of Silid-State-circuits, Vol 27 , No.12, Dec 1992, pp. 1736-1745 bekannten Phasenvergleichers nach Hogge weist die Kontrolleinheit einen Datenmultiplexer auf.

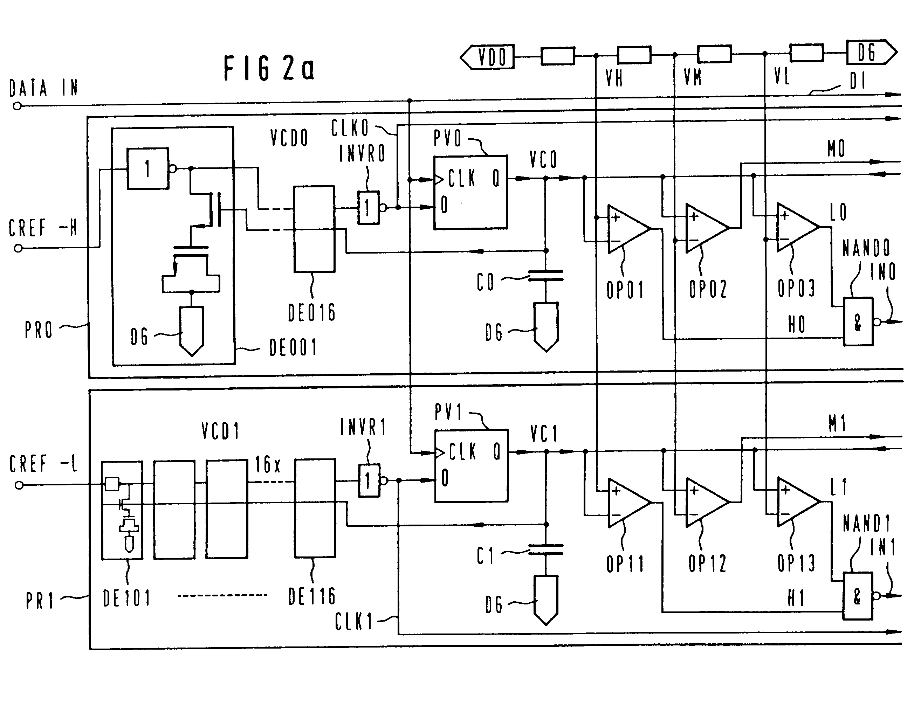

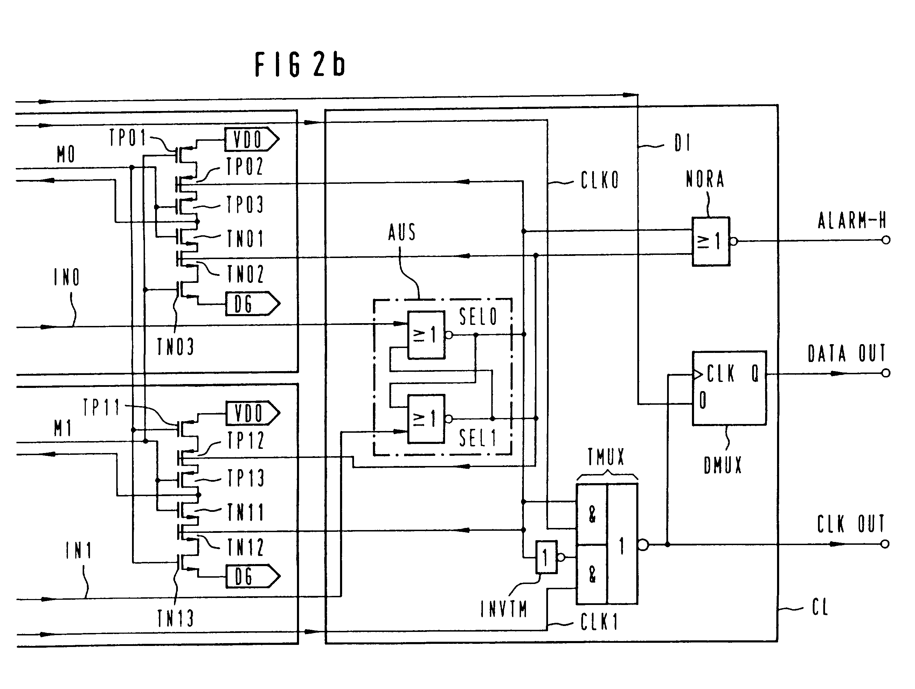

Fig 2 zeigt eine einfache Ausführungsform einer in CMOS-(Complementary Metal Oxid Silicium) - Technologie realisierten Schaltungsanordnung auf der Bauteileebene. Die Verzögerungsleitungen sind jeweils mit 16 Verzögerungselementen DE001 .. DE016, bzw. DE101 .. DE116 (für: Delay Element) gebildet. Jedes Verzögerungselement ist mit einem Inverter gebildet, der ausgangsseitig über einen regelbaren Widerstand mit einer Lastkapazität belastet ist. Die beiden Anschlüße der Laststrecke des regelbaren Widerstandes sind durch die beiden Hauptelektroden eines ersten N-Kanal Feldeffekttransistors gegeben, wobei die Steuerelektrode des Feldeffekttransistors mit der Steuerspannung beaufschlagt ist. Die Lastkapazität ist mit der Kapazität zwischen der Steuerelektrode und der Laststrecke eines zweiten N-Kanal Feldeffekttransistors gebildet, wobei die Steuerelektrode des zweiten Feldeffekttransistors mit der Source-Elektrode des ersten Feldeffekttransistors und die beiden Hauptelektroden des zweiten Feldeffekttransistors mit der das niedrige Potential führenden Klemme DG einer nicht näher dargestellten Betriebsspannungsquelle VDD - DG verbunden sind. Der Ausgang eines Verzögerungselementes ist durch den mit einer gesteuerten Lastkapazität belasteten Ausgang eines Inverters gegben. Der Ausgang eines Verzögerungselementes ist mit dem Eingang des jeweils nächsten Verzögerungselementes verbunden; der Ausgang des letzten Verzögerungselementes der Verzögerungsleitung ist mit einem Inverter INVR0, INVR1 zur Regeneration der Impulsform verbunden. Der Ausgang des betrachteten Inverters INVR0, INVR1 ist mit dem D-Eingang eines D-Flipflops DFF0, DFF1 ,das den betreffenden Phasenvergleicher PV0, PV1 bildet, verbunden. Dem Eingang CLK des D-Flipflops ist der Datenstrom zugeführt. Mit jeder steigenden Flanke des Datenstroms wird der augenblickliche Zustand des verzögerten Referenztaktsignals am Ausgang des D-Flipflops übernommen. In diesem Auführungsbeispiel ist das Schleifenfilter durch einen Kondensator C0, C1 gebildet, der einerseits mit dem Ausgang des Phasenvergleichers und andererseits mit der das niedrige Potential führenden Klemme DG der Betriebsspannungsquelle VDD - DG verbunden ist. Der Kondensator C0, C1 integriert den von dem zugehörigen Phasenvergleicher gelieferten Ausgangsstrom. Die Spannung über dem Kondensator C0, C1 ist sämtlichen Verzögerungselementen der zugehörigen Verzögerungsleitung zugeführt. In Anwendungsfällen mit einer geringen Anzahl von Zustandswechseln des Datenstromes bezogen auf einen Betrachtungszeitraum können anstelle des Kondensators C0, C1 andere, z.B. aus R. Best "Theorie und Anwendung des Phase-locked Loops", AT Verlag Aarau - Stuttgart ISBN 3-85502-123-6 bekannte Schleifenfilter zum Einsatz kommen. Die Verzögerungsleitung, der Phasenvergleicher und der Schleifenfilter bilden einen Regelkreis, wobei der Phasenvergleicher so regelt, daß eine steigende Flanke in dem Datenstrom mit der steigenden Flanke des verzögerten Referenztaktsignals zusammenfällt.

Für jeden Phasenregler wird die Steuerspannung daraufhin überwacht, ob sie einen Wert oberhalb oder unterhalb einer hohen Spannung UH, einer mittleren Spannung UM bzw. einer niedrigen Spannung UL aufweist. Ein mit 4 Widerständen R1, R2, R3 und R4 gebildeter Spannungsteiler ist mit den beiden Klemmen der Betriebsspannungsquelle VDD - DG verbunden. Der Spannungsteiler stellt die hohe Spannung UH, die mittlere Spannung UM und die niedrige Spannung UL bereit. Jedem Phasenregler sind 3 Differenzverstärker OP01, OP02, OP03, bzw.OP11, OP12, OP13 zugeordnet. Die Differenzverstärker OP01 und OP11 sind an ihrem nichtinvertierenden Eingang (+) mit der hohen Spannung UH und an ihrem invertierenden Eingang (-) mit der zugehörigen Steuerspannung VC0, VC1 beaufschlagt. Die Differenzverstärker OP02 und OP12 sind an ihrem invertierenden Eingang (-) mit der mittleren Spannung UM und an ihrem nichtinvertierenden Eingang (+) mit der zugehörigen Steuerspannung VC0, VC1 beaufschlagt. Die Differenzverstärker OP03 und OP13 sind an ihrem invertierenden Eingang (-) mit der niedrigen Spannung UL und an ihrem nichtinvertierenden Eingang (+) mit der zugehörigen Steuerspannung VC0, VC1 beaufschlagt. Die von den Differenzverstärkern OP01 und OP03 bzw. OP11 und OP13 abgegebenen Ausgangssignale H0, L0 bzw. H1, L1 sind den Eingängen eines die logische NAND-Funktion realisierenden Nand-Gatters NAND0, bzw. NAND1 zugeführt. Die Differenzverstärker OP01 und OP03 bzw. OP11 und OP13 bilden gemeinsam mit dem Nand-Gatter NAND0, bzw. NAND1 einen Fensterkomparator, wobei das Nand-Gatter NAND0, bzw. NAND1 an seinem Ausgang dann ein Signal IN0, IN1 mit niedrigem Pegel (LOW) abgibt, wenn die Steuerspannung niedriger als die hohe Spannung UH und höher als die niedrige Spannung UL ist. Ein Signal IN0, IN1 mit niedrigem Pegel (LOW) gibt also an, daß der zugehörige Phasenregler einen Zustand innerhalb seines Regelbereiches innehat, wohingegen ein Signal IN0, IN1 mit hohem Pegel (HIGH) angibt, daß der zugehörige Phasenregler einen Zustand außerhalb seines Regelbereiches eingenommen hat. Die Spannung UH und die Spannung UL bilden also die Grenzen eines definierten Regelbereiches.

Die von den Fensterkomparatoren abgegebenen Signale IN0 und IN1 sind einer Auswahleinrichtung AUS zugeführt. Die Auswahleinrichtung wählt für den Fall, daß ein Verlassen des Regelbereiches des gerade ausgewählten Phasenreglers durch das zugehörige Signal IN0, IN1 mit hohem Pegel (HIGH) angezeigt wird, einen anderen Phasenregler aus, der einen Zustand innerhalb seines Regelbereiches eingenommen hat. Die Auswahleinrichtung im Ausführungsbeispiel ist mit zwei die logische NOR-Funktion realisierenden NOR-Gattern gebildet, die in an sich bekannter Weise zu einem RS-Flipflop verschaltet sind. Die Auswahleinrichtung vermag also an ihren Ausgängen SEL0, SEL1 (für: SELECT) die Zustände eines RS-Flipflops einzunehmen.

Ein Taktmultiplexer TMUX wird nach Maßgabe des Signalzustandes am Ausgang SEL0 der Auswahleinrichtung gesteuert. Der Taktmultiplexer ist mit zwei die logische UND-Funktion realisierenden UND-Gattern gebildet, deren Ausgänge über ein die logische NOR-Funktion realisierendes NOR-Gatter verknüpft sind. Den UND-Gattern sind jeweils einerseits die von den Verzögerungsleitungen verzögerten Referenztaktsignale CLK0, CLK1 und andererseits der Signalzustand am Ausgang SEL0 der Auswahleinrichtung bzw. der über einen Inverter INVTM invertierte Zustand dieses Signalzustandes zugeführt. Der Taktmultiplexer schaltet also bei einem hohen Signalzustand am Ausgang SEL0 der Auswahleinrichtung das von der Verzögerungsleitung VCD0 verzögerte Referenztaktsignal CLK0 in invertierter Form auf die Klemme CLKOUT der Kontrolleinheit durch, wohingegen bei einem niedrigen Signalzustand am Ausgang SEL0 der Auswahleinrichtung das von der Verzögerungsleitung VCD1 verzögerte Referenztaktsignal CLK1 in invertierter Form auf die Klemme CLKOUT durchgeschaltet wird. Bedingt durch die Invertierung in dem Taktmultiplexer erscheint das Taktsignal an der Klemme CLKOUT gegenüber dem Taktsignal am Eingang des gerade ausgewählten Phasenvergleichers um eine halbe Taktperiode verschoben. Ein Datenmultiplexer DMUX ist mit einem D-Flipflop gebildet, wobei dem D-Eingang der Datenstrom DATAIN und dem CLK-Eingang das Taktsignal an der Klemme CLKOUT zugeführt ist. Mit jeder steigenden Flanke des Taktsignals an der Klemme CLKOUT wird der Datenstrom in der Mitte einer nächstfolgenden Bitübertragungszeitspanne abgetaktet.

Für jeden Phasenregler ist eine Serienschaltung von 3 aneinandergereihten P-Kanal-Feldeffekttransistoren TP01, TP02, TP03 bzw. TP11, TP12, TP13 und 3 aneinandergereihten N-Kanal-Feldeffekttransistoren TN01, TN02, TN03 bzw. TN11, TN12, TN13 gegeben. Die Source-Elektrode des außenliegenden P-Kanal-Feldeffekttransistors TP01 bzw. TP11 ist mit der das hohe Potential führenden Klemme VDD und die Source-Elektrode des außenliegenden N-Kanal-Feldeffekttransistors TN03 bzw. TN13 ist mit der das niedrige Potential führenden Klemme DG der Betriebsspannungsquelle verbunden. Die Mittenanzapfung der Serienschaltung ist mit der zugehörigen Steuerspannung verbunden.

Der Differenzverstärker OP02 bzw. OP12 gibt an seinem Ausgang ein Signal mit hohem Pegel (HIGH) ab, wenn die zugehörige Steuerspannung höher ist als die mittlere Spannung UM. Der Ausgang des Differenzverstärkers OP02 bzw. OP12 ist mit den Steuerelektroden der Feldeffekttransistoren TP03 und TN01 bzw. TP13 und TN11 der zugehörigen Serienschaltung sowie mit den Steuerelektroden der Feldeffekttransistoren TP11 und TN13 bzw. TP01 und TN03 der einem jeweiligen anderen Phasenregler zugehörigen Serienschaltung verbunden. Der Ausgang SEL0 der Auswahleinrichtung ist mit den Steuerelektroden der Feldeffekttransistoren TP02 und TN12 verbunden. Der Ausgang SEL1 der Auswahleinrichtung ist mit den Steuerelektroden der Feldeffekttransistoren TN02 und TP12 verbunden. Ist nun der Phasenregler PR0 durch ein Signal mit hohem Pegel am Ausgang SEL0 der Auswahleinrichtung gerade ausgewählt, so sind die Feldeffekttransistoren TP02 und TN02 gesperrt und die Feldeffekttransistoren TP12 und TN12 leitend geschaltet. Die Serienschaltung des gerade ausgewählten Phasenreglers ist also gesperrt, womit sie keinen Einfluß auf die zugehörige Steuerspannung hat. Die Serienschaltung eines gerade nicht ausgewählten Phasenreglers wird in der Weise leitend geschaltet, daß die Höhe der Steuerspannung dieses Phasenreglers in Richtung auf die bezüglich der mittleren Spannung UM jeweils andere Seite des Regelbereiches beeinflußt wird wie die Seite des Regelbereiches, in den die augenblickliche Höhe der Steuerspannung des gerade ausgewählten Phasenreglers fällt. Diese Beeinflussung geht so weit, bis die Steuerspannung die mittlere Spannung überschritten hat und durch eine Zustandsänderung am Ausgang des Differenzverstärkers OP02, bzw. OP12 des gerade nicht ausgewählten Phasenreglers die zugehörige Serienschaltung für eine weitere Beeinflussung der Steuerspannung gesperrt wird. Weist die Steuerspannung eines gerade nicht ausgewählten Phasenreglers eine Höhe auf, die bereits in die bezüglich der mittleren Spannung UM jeweils andere Seite des Regelbereiches fällt wie die Seite des Regelbereiches, in die die augenblickliche Höhe der Steuerspannung des gerade ausgewählten Phasenreglers fällt, so bleibt die Serienschaltung des gerade nicht ausgewählten Phasenreglers gesperrt, womit die zugehörige Steuerspannung nicht beeinflußt wird.

Für den Fall, daß die Steuerspannungen sämtlicher Phasenregler einen Zustand außerhalb ihres Regelbereiches eingenommen haben, weisen sämtliche der Auswahleinrichtung zugeführte Signale IN0, IN1 einen hohen Pegel (HIGH) auf, wodurch die Auswahleinrichtung an ihren Ausgängen SEL0, SEL1 einen niedrigen Pegel (LOW) einnimmt. Dies wird von einem die logische NOR-Funktion realisierenden NOR-Gatter ausgewertet und an der Klemme ALARM durch ein Signal mit hohem Pegel (HIGH) angezeigt.

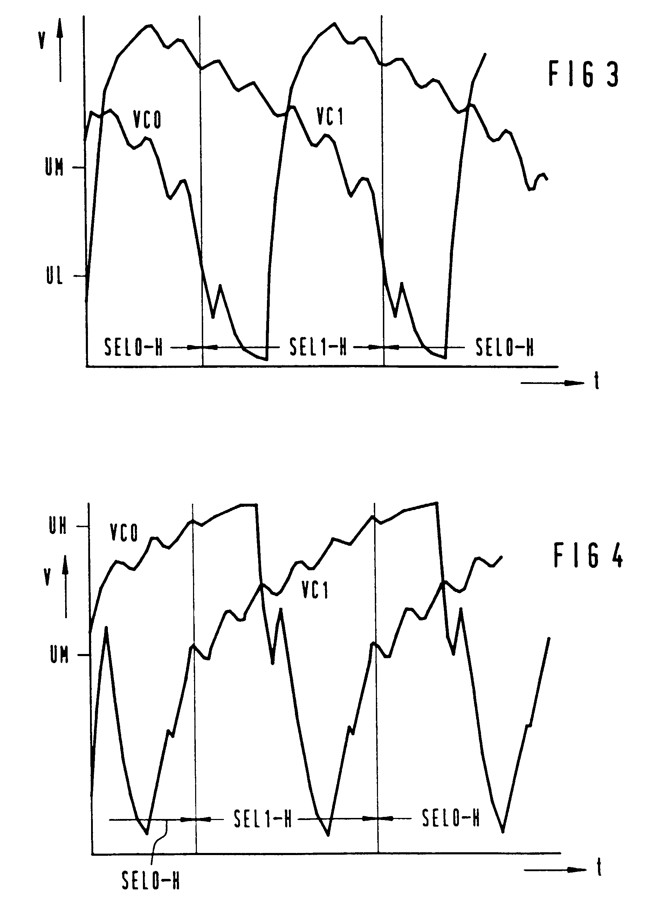

In FIG 3 und FIG4 sind im Zuge einer Schaltungssimulation erhaltene Verläufe der Steuerspannungen VC0, VC1 und der an den Ausgängen der Auswahleinrichtung anliegenden Signale SEL0, SEL1 dargestellt. Die Abweichung zwischen der Bitfolgerate des Datenstromes und der Taktrate des Referenztaktsignals beträgt in beiden Fällen 1 Promille.

In FIG 3 ist die Bitfolgerate des Datenstromes höher als die Taktrate des Referenztaktsignals, womit der gerade ausgewählte Phasenregler die Verzögerung des Referenztaktsignals fortschreitend verringert, während der gerade nicht ausgewählte Phasenregler in dem augenblicklichen Zustand mit einer langen Verzögerung bereitgehalten wird.

In FIG 4 ist die Bitfolgerate des Datenstromes niedriger als die Taktrate des Referenztaktsignals, womit der gerade ausgewählte Phasenregler die Verzögerung des Referenztaktsignals fortschreitend erhöht, während der gerade nicht ausgewählte Phasenregler in dem augenblicklichen Zustand mit einer kurzen Verzögerung bereitgehalten wird.

Den Darstellungen in den FIG 3 und FIG 4 liegt ein phasenmodulierter Datenstrom mit einer Modulationsfrequenz von 2 MHz zugrunde. Die Phasenmodulation verursacht im Verlauf der Steuerspannungen Störungen, die im gewellten Verlauf der Steuerspannungen gut zu erkennen sind.

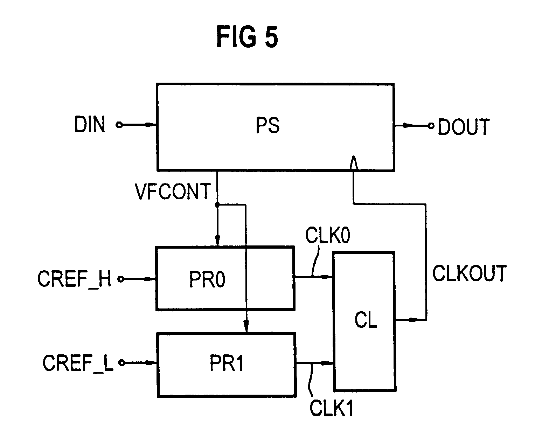

Fig 5 zeigt eine Schaltungsanordnung zur Aussendung eines Datensignales in einem digitalen Übertragungsystem. Das Datensignal ist dem Eingang DIN eines Pufferspeichers PS zugeführt. Zwei Phasenreglern PR0, PR1 sind eingangsseitig jeweils eines von zueinander komplementären Referenztaktsignalen CREF_H, CREF_L zugeführt. Die Kontrolleinheit CL wählt einen Phasenregler aus, dessen ausgangsseitig abgegebenes Taktsignal CLK0, CLK1 als Taktsignal CLKOUT zur Aussendung des Datensignales an dem Ausgang DOUT des Pufferspeichers auf eine Leitung dient. Die Frequenz des von dem ausgewählten Phasenregler abgegebenen Taktsignals wird nach Maßgabe des von dem Pufferspeicher abgegebenen Füllstandssignals VFCONT beeinflußt.

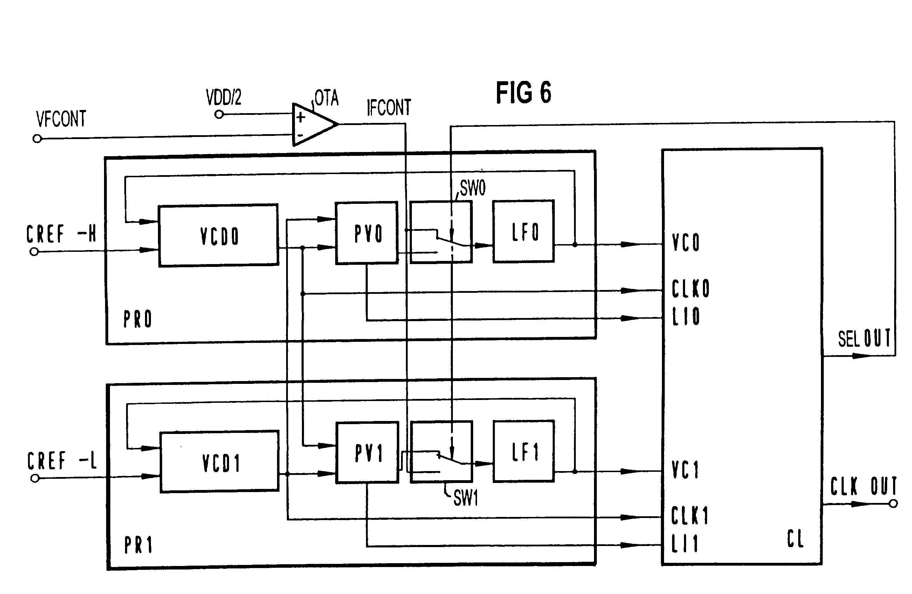

Die Blockschaltung in Fig 6 weist zwei Phasenregler PR0, PR1 und eine Kontrolleinheit CL (für: Control-Logic) auf. Den Phasenreglern wird als Eingangssignal ein Referenztaktsignal CREF mit gegebener, in hohem Maße stabiler Frequenz zugeführt. Das Referenztaktsignal kann durch ein lokal ohnehin vorhandenes Taktsignal gegeben sein. Den Phasenreglern werden jeweils zueinander komplementäre Referenztaktsignale CREF_H, CREF_L zugeführt. In einem Phasenregler wird das betreffende Referenztaktsignal einer spannungsgesteuerten Verzögerungsleitung VCD0, VCD1 zugeführt. In der Verzögerungsleitung wird das Referenztaktsignal nach Maßgabe einer zugeführten Steuerspannung VC0, VC1 verzögert. Das von der Verzögerungsleitung abgegebene Taktsignal und das von der Verzögerungsleitung eines anderen Phasenreglers abgegebene Taktsignal werden einem Phasenvergleicher PV0, PV1 als Eingangssignale zugeführt. Der Phasenvergleicher liefert nach Maßgabe der Koinzidenz der ihm zugeführten Eingangssignale einen Strom als Ausgangssignal. Der von dem Phasenvergleicher gelieferte Strom ist einem ersten Eingang eines gesteuerten Umschalters SW0, SW1 zugeführt. Dem zweiten Eingang sämtlicher gesteuerter Umschalter ist der von einem Spannungs-Strom-Umsetzer OTA (für: Operational Transconductance Amplifier) gelieferte Strom IFCONT zugeführt. Der nichtinvertierende Eingang des Spannungs-Strom-Umsetzers ist mit dem mittleren Potential U_{DD}/2 einer nicht näher dargestellten Betriebsspannungsquelle, die an ihren beiden Klemmen die Potentiale UDD, DG zur Verfügung stellt, verbunden. Dem invertierenden Eingang des Spannungs-Strom-Umsetzers ist ein Spannungssignal VFCONT zugeführt. Der Spannungs-Strom-Umsetzer setzt das Spannungssignal VFCONT in einen entprechend hohen positiven oder negativen Strom um. Das Spannungssignal VFCONT möge durch ein diskretes Signal, das die Abweichung des Füllstandes eines Pufferspeichers vom Sollwert angibt, gegeben sein. Die Rate der Zustandswechsel des Spannungssignales VFCONT möge klein sein im Vergleich zur Frequenz des Referenztaktsignales. Das von dem gesteuerten Umschalter ausgangsseitig gelieferte Signal wird einem Schleifenfilter LF0, LF1 zugeführt. In dem Schleifenfilter erfährt das zugeführte Signal eine an sich für Phasenregelkreise (Phase-locked-loop) bekannte Behandlung mit integrierender Wirkung. Im vorliegenden Fall wird in dem Schleifenfilter ein von dem Phasenvergleicher oder dem Spannungs-Strom-Umsetzer gelieferter Strom konstanter Höhe in ein linear ansteigendes Spannungssignal umgesetzt. Das von dem Schleifenfilter abgegebene Spannungssignal wird einerseits der Verzögerungsleitung als Steuerspannung VC0, VC1 und andererseits der Kontrolleinheit über gleichbezeichnete Anschlüsse zugeführt. Die Kontrolleinheit gibt unter Auswertung der ihr eingangsseitig zugeführten Signale an der Klemme CLKOUT ein Taktsignal ab, das eine niedrigere, die gleiche oder eine höhere Taktfrequenz als das Referenztaktsignal CREF aufweisen kann. Das an der Klemme CLKOUT abgegebene Taktsignal kann also gegenüber dem Referenztaktsignal dauerhaft eine etwas höhere oder eine etwas niedrigere Frequenz aufweisen. Zum Ausgleich der Frequenzdifferenz zwischen dem Referenztaktsignal und dem Taktsignal CLKOUT wird das Referenztaktsignal in einer Verzögerungsleitung zunehmend phasenverschoben. Das an der Klemme CLKOUT abgegebene Taktsignal ist dem Pufferspeicher zugeführt, dessen Inhalt mit der Frequenz des Taktsignales ausgelesen wird.

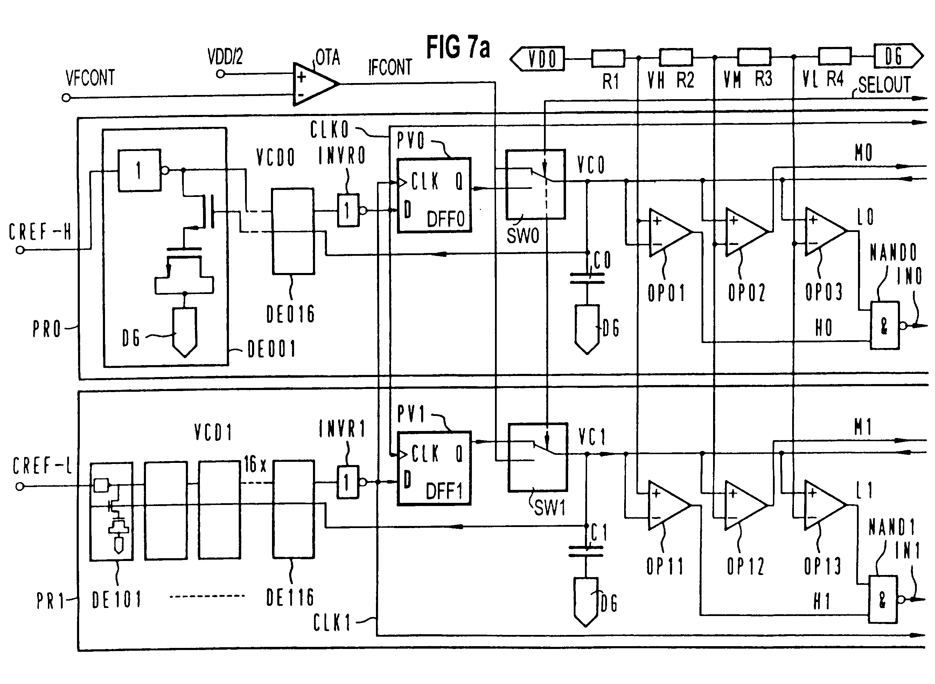

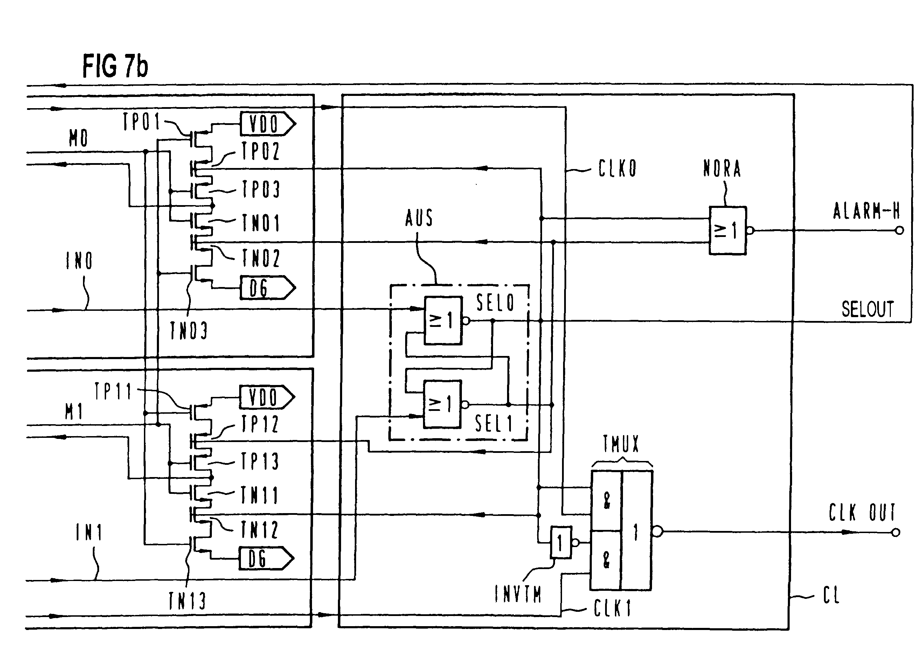

Durch die Kontrolleinheit wird stets ein Phasenregler ausgewählt, dessen Taktsignal auf die Klemme CLKOUT durchgeschaltet wird. In der Fig 6 und Fig 7 ist der Phasenregler PR 1 als der ausgewählte Phasenregler dargestellt. Bei einem ausgewählten Phasenregler ist das Ausgangssignal des Spannungs-Strom-Umsetzers über den gesteuerten Umschalter SW dem zugehörigen Schleifenfilter zugeführt. Die Frequenz des von dem ausgewählten Phasenregler abgegebenen Taktsignales ist also nach Maßgabe des dem Spannungs-Strom-Umsetzer zugeführten Spannungssignales VFCONT gesteuert. In Fig 6 und Fig 7 ist der Phasenregler PR 2 als momentan nicht ausgewählter Phasenregler dargestellt. Bei einem nicht ausgewählten Phasenregler ist der Phasenregelkreis über den gesteuerten Umschalter geschlossen, wobei der Phasenregelkreis auf die Frequenz des momentan ausgewählten Phasenreglers einrastet. Die Einrastung des nicht ausgewählten Phasenreglers auf die Frequenz des ausgewählten Phasenreglers ermöglicht eine Umschaltung ohne Phasensprung. Da die beiden Phasenregler eingangsseitig mit zueinander komplementären Referenztaktsignalen beaufschlagt sind, weisen der ausgewählte Phasenregler und der nicht ausgewählte Phasenregler im allgemeinen voneinander abweichende Steuerspannungen VC0, VC1 auf.

Im Übrigen gilt für die Kontrolleinheit in Fig 6 das für die Kontrolleinheit in Fig 1 gesagte entsprechend mit folgender Ergänzung. Die Kontrolleinheit gibt ein Signal SELOUT ab, das seinen Zustand mit dem Auswahlzustand der Kontrolleinheit ändert und das eine Umschaltung der gesteuerten Umschalter bewirkt.

Für die Fig 7 a, b gilt das für die Fig 2a, 2b gesagte mit folgenden Abweichungen. Dem Eingang CLK des D-Flipflops (DFF0, DFF1) ist das von der Verzögerungsleitung des jeweils anderen Phasenreglers abgegebene Taktsignal zugeführt. Mit jeder steigenden Flanke des von dem jeweils anderen Phasenregler abgegebenen Taktsignales wird der augenblickliche Zustand des zugehörigen Taktsignals am Ausgang des D-Flipflops übernommen. Der Ausgang des Phasenvergleichers ist einem Eingang eines gesteuerten Umschalters, der in an sich bekannter Weise mit Transistorschaltern realisiert sein möge, zugeführt. Das Signal am Ausgang des Phasenvergleichers des momentan ausgewählten Phasenreglers ist ungenutzt. Der Ausgangsstrom des Phasenvergleichers des momentan nicht ausgewählten Phasenreglers ist über den zugehörigen gesteuerten Umschalter dem mit einem Kondensator C0, C1 gebildeten Schleifenfilter zugeführt und wird dort integriert. Die Spannung über dem Kondensator C0, C1 ist sämtlichen Verzögerungselementen der zugehörigen Verzögerungsleitung zugeführt. Bei dem momentan nicht ausgewählten Phasenregler bilden die Verzögerungsleitung, der Phasenvergleicher und der Schleifenfilter über den gesteuerten Umschalter einen geschlossenen Regelkreis, wobei der Phasenvergleicher so regelt, daß an seinem Eingang die steigenden Flanken des Taktsignales CLK0 und des Taktsignales CLK1 zeitgleich sind.

Das am Ausgang SEL0 der Auswahleinrichtung abgegebene Signal ist als Umschaltsignal SELOUT den gesteuerten Umschaltern SW0, SW 1 zugeführt.

Die Kontrolleinheit erzwingt, daß die Steuerspannung eines momentan nicht ausgewählten Phasenreglers in einem bezüglich der mittleren Spannung diametralen Arbeitsbereich zu dem Arbeitsbereich des gerade ausgewählten Phasenreglers gehalten wird, sodaß der momentan nicht ausgewählte Phasenregler nur in diesem Zustand einrasten kann.

Der Einfluß von Störungen an den Klemmen der Betriebsspannungsquelle ist umso geringer, je kürzer die Verzögerungszeit in einer Verzögerungsleitung ist. In einer bevorzugten Ausführungsform sind die Phasenregler in zwei Gruppen aufgeteilt, wobei den Gruppen jeweils zueinander komplementäre Referenztaktsignale zugeführt sind. Diese Maßnahme bringt neben einer Verringerung des Einflußes von durch Störungen an den Klemmen der Betriebsspannungsquelle verursachten Störungen eine Einsetzbarkeit von kürzeren und damit aufwandsärmeren Verzögerungsleitungen mit sich. Die Verzögerungsleitung ist dann so ausgelegt, daß sie nur eine halbe Periode des Taktsignales auzugleichen braucht und vermag.

## Patentansprüche

1. Verfahren zur Gewinnung eines Taktsignales (CLKOUT) in einer Schaltungsanordnung mit mehreren jeweils eine Verzögerungsleitung (VCD0, VCD1), einen Phasenvergleicher (PV0, PV1) und einen Schleifenfilter (LF0, LF1) aufweisenden Phasenreglern (PR0, PR1), deren Steuerspannungen (VC0, VC1) in einem Regelbereich zwischen einer oberen (UH) und einer unteren (UL) Grenze ausgesteuert werden können
demzufolge
- den Verzögerungsleitungen der Phasenregler eingangsseitig ein Referenztaktsignal (CREF_H, CREF_L) zugeführt wird
- ein Phasenregler ausgewählt wird, dessen ausgangsseitig abgegebenes Signal als das Taktsignal gegeben ist
- die Verzögerungsdauer des ausgewählten Phasenreglers nach Maßgabe eines Ansteuersignales beeinflußt wird
- bei Aussteuerung an die obere oder die untere Grenze des Regelbereiches des gerade ausgewählten Phasenreglers ein jeweiliger anderer Phasenregler ausgewählt wird, dessen Steuerspannung gerade nicht an dieser Grenze ausgesteuert ist.

2. Verfahren nach Anspruch 1
**dadurch gekennzeichnet,**
daß ein Datensignal (DATAIN) als Ansteuersignal dem Phasenvergleicher des ausgewählten Phasenreglers zugeführt wird und
daß das von diesem Phasenregler ausgangsseitig abgegebene Signal das dem Datensignal zugehörige Taktsignal bildet.

3. Verfahren nach Anspruch 1
**dadurch gekennzeichnet, daß**
das Füllstandssignal eines Pufferspeichers dem Schleifenfilter des ausgewählten Phasenreglers als Ansteuersignal zugeführt wird und
daß das von diesem Phasenregler ausgangsseitig abgegebene Signal das Taktsignal zum Auslesen des Pufferspeichers bildet.

4. Verfahren nach einem der Ansprüche 1 bis 3
**dadurch gekennzeichnet, daß**
ein gerade nicht ausgewählter Phasenregler im wesentlichen an der jeweils anderen Grenze wie der gerade ausgewählte Phasenregler eingerastet bereitgehalten wird.

5. Verfahren nach einem der Ansprüche 1 bis 4
**dadurch gekennzeichnet, daß**
die Phasenregler in zwei Gruppen eingeteilt sind und den Gruppen jeweils eines von zueinander komplementären Referenztaktsignalen (CREF_H, CREF_L) zugeführt werden.

6. Schaltungsanordnung zur Gewinnung eines Taktsignales (CLKOUT), bei der
- mehrere jeweils eine gesteuerte Verzögerungsleitung (VCD0, VCD1), einen Phasenvergleicher (PV0, PV1) und einen Schleifenfilter (LF0, LF1) aufweisende Phasenregler (PR0, PR1) gegeben sind, deren Steuerspannungen in einem Regelbereich zwischen einer oberen (UH) und einer unteren (UL) Grenze aussteuerbar sind
- den Eingängen der Verzögerungsleitungen der Phasenregler ein Referenztaktsignal (CREF0, CREF1) zugeführt ist
- ein Phasenregler ausgewählt ist, dessen ausgangsseitig abgegebenes Signal als das Taktsignal gegeben ist
- die Verzögerungsdauer des ausgewählten Phasenreglers nach Maßgabe eines Ansteuersignales beeinflußt ist
- bei Aussteuerung an die obere oder die untere Grenze des Regelbereiches des gerade ausgewählten Phasenreglers ein jeweiliger anderer Phasenregler auswählbar ist, dessen Steuerspannung gerade nicht an dieser Grenze ausgesteuert ist.

7. Schaltungsanordnung nach Anspruch 6
**dadurch gekennzeichnet**,
daß ein Datensignal (DATAIN) als Ansteuersignal einem Eingang des Phasenvergleichers des ausgewählten Phasenreglers zugeführt ist und
daß das von der Verzögerungsleitung dieses Phasenreglers ausgangsseitig abgegebene Signal das dem Datensignal zugehörige Taktsignal bildet.

8. Schaltungsanordnung nach Anspruch 6
**dadurch gekennzeichnet**,
dem Eingang Schleifenfilter des ausgewählten Phasenreglers das Füllstandssignal eines Pufferspeichers als Ansteuersignal zugeführt ist und
daß das am Ausgang dieses Phasenreglers abgegebene Signal das Taktsignal zum Auslesen des Pufferspeichers bildet.

9. Schaltungsanordnung nach einem der Ansprüche 6 bis 8
**gekennzeichnet durch**
einen gerade nicht ausgewählten Phasenregler, der im eingerasteten Zustand einer Aussteuerung auf der jeweils anderen Seite bezüglich der Mitte des Regelbereiches wie der gerade ausgewählte Phasenregler bereitgehalten ist.

10. Schaltungsanordnung nach einem der Ansprüche 6 bis 9
**gekennzeichnet durch**
in zwei Gruppen eingeteilte Phasenregler, wobei den Verzögerungsleitungen jeder Gruppe von Phasenreglern eines von zueinander komplementären Referenztaktsignalen (CREF_H, CREF_L) zugeführt ist.

11. Schaltungsanordnung nach einem der Ansprüche 5 bis 9
**dadurch gekennzeichnet, daß**
der Schaltungsanordnung ein lokal vorhandenes Taktsignal zum Aussenden eines Datenstromes als Referenztaktsignal zugeführt ist.

## Claims

1. Method for obtaining a timing signal (CLKOUT) in a circuit arrangement having a plurality of phase regulators (PR0, PR1) which each have a delay line (VCD0, VCD1), a phase comparator (PV0, PV1) and a loop filter (LF0, LF1) and whose control voltages (VC0, VC1) can be driven in a control range between an upper limit (UH) and a lower limit (UL)
as a result of which
- a reference timing signal (CREF_H, CREF_L) is supplied on the input side to the delay lines of the phase regulators
- a phase regulator is selected whose signal which is emitted on the output side is defined as the timing signal
- the delay duration of the selected phase regulator is influenced on the basis of a drive signal
- if the currently selected phase regulator is driven to its upper or lower control range limit, a respective different phase regulator is selected whose control voltage is just not driven to this limit.

2. Method according to Claim 1,
characterized
in that a data signal (DATAIN) is supplied as the drive signal to the phase comparator of the selected phase regulator, and in that the signal which is emitted on the output side from this phase regulator forms the timing signal which is associated with the data signal.

3. Method according to Claim 1,
characterized in that
the filling level signal of a buffer store is supplied to the loop filter of the selected phase regulator as a drive signal, and
in that the signal which is emitted on the output side from this phase regulator forms the timing signal for reading from the buffer store.

4. Method according to one of Claims 1 to 3
characterized in that
a phase regulator which has currently not been selected is kept ready and is essentially locked in to the respective other limit like that of the currently selected phase regulator.

5. Method according to one of Claims 1 to 4
characterized in that
the phase regulators are split into two groups and one of mutually complementary reference timing signals (CREF H, CREF L) is supplied to each of the groups.

6. Circuit arrangement for obtaining a timing signal (CLKOUT) in which
- a plurality of phase regulators (PR0, PR1) are provided which each have a controlled delay line (VCD0, VCD1), a phase comparator (PV0, PV1) and a loop filter (LF0, LF1) and whose control voltages can be driven in a control range between an upper limit (UH) and a lower limit (UL)
- a reference timing signal (CREF0, CREF1) is supplied to the inputs of the delay lines of the phase regulators
- a phase regulator is selected whose signal which is emitted on the output side is defined as the timing signal
- the delayed duration of the selected phase regulator is influenced on the basis of a drive signal
- if the currently selected phase regulator is driven to its upper or lower control range limit, a respective different phase regulator can be selected whose control voltage is just not driven to this limit.

7. Circuit arrangement according to Claim 6
characterized,
in that a data signal (DATAIN) is supplied as a drive signal to one input of the phase comparator of the selected phase regulator, and
in that the signal which is emitted on the output side from the delay line of this phase regulator forms the timing signal which is associated with the data signal.

8. Circuit arrangement according to Claim 6,
characterized
in that the filling level signal of a buffer store is supplied to the input of a loop filter of the selected phase regulator as a drive signal, and
in that the signal which is emitted at the output of this phase regulator forms the timing signal for reading from the buffer store.

9. Circuit arrangement according to one of Claims 6 to 8
characterized by
a phase regulator which is currently not selected and is kept in the locked-in state of a drive on the respectively other side with respect to the centre of the control range like the currently selected phase regulator.

10. Circuit arrangement according to one of Claims 6 to 9
characterized by
phase regulators which are split into two groups, one of mutually complementary reference timing signals (CREF_H, CREF_L) being supplied to the delay lines of each group of phase regulators.

11. Circuit arrangement according to one of Claims 5 to 9
characterized in that
a locally existing timing signal is supplied to the circuit arrangement, in order to transmit a data stream as a reference timing signal.

## Revendications

1. Procédé pour l'obtention d'un signal d'horloge (CLKOUT) dans un circuit ayant plusieurs régulateurs de phases (PR0, PR1) qui comportent chacun une ligne à retard (VCD0, VCD1), un comparateur de phase (PV0, PV1) et un filtre de boucle (LF0, LF1) et dont les tensions de commande (VC0, VC1) peuvent être commandées dans une gamme de réglage comprise entre une limite supérieure (UH) et une limite inférieure (UL), dans lequel
- les lignes à retard des régulateurs de phases reçoivent en entrée un signal d'horloge de référence (CREF_H, CREF_L),
- on sélectionne un régulateur de phase dont le signal délivré en sortie est donné comme signal d'horloge,
- on influence le retard du régulateur de phase sélectionné en fonction d'un signal de commande,
- lors d'une commande à la limite supérieure ou à la limite inférieure de la gamme de réglage du régulateur de phase actuellement sélectionné, on sélectionne un autre régulateur de phase respectif dont la tension de commande n'est pas commandée actuellement à cette limite.

2. Procédé selon la revendication 1,
caractérisé par le fait qu'on envoie un signal de données (DATAIN) comme signal de commande au comparateur de phase sélectionné et que le signal délivré en sortie par ce régulateur de phase forme le signal d'horloge associé au signal de données.

3. Procédé selon la revendication 1,
caractérisé par le fait qu'on envoie le signal d'état de remplissage d'une mémoire tampon comme signal de commande au filtre de boucle du régulateur de phase sélectionné et que le signal délivré en sortie par ce régulateur de phase forme le signal d'horloge pour lire la mémoire tampon.

4. Procédé selon l'une des revendications 1 à 3,
caractérisé par le fait qu'on tient prêt un régulateur de phase actuellement non sélectionné verrouillé à l'autre limite respective à l'opposé du régulateur de phase actuellement sélectionné.

5. Procédé selon l'une des revendications 1 à 4,
caractérisé par le fait qu'on divise les régulateurs de phases en deux groupes et qu'on envoie aux groupes à chaque fois un des signaux d'horloge de référence (CREF_H, CREF_L) complémentaires l'un de l'autre.

6. Circuit pour l'obtention d'un signal d'horloge (CLKOUT), dans lequel
- il y a plusieurs régulateurs de phases (PR0, PR1) qui comportent chacun une ligne à retard commandée (VCD0, VCD1), un comparateur de phase (PV0, PV1) et un filtre de boucle (LF0, LF1) et dont les tensions de commande peuvent être commandées dans une gamme de réglage comprise entre une limite supérieure (UH) et une limite inférieure (UL),
- un signal d'horloge de référence (CREF0, CREF1) est envoyé aux entrées des lignes à retard des régulateurs de phases,
- un régulateur de phase dont le signal délivré en sortie est donné comme signal d'horloge est sélectionné,
- le retard du régulateur de phase sélectionné est influencé en fonction d'un signal de commande,
- lors d'une commande à la limite supérieure ou à la limite inférieure de la gamme de réglage du régulateur de phase actuellement sélectionné, un autre régulateur de phase respectif dont la tension de commande n'est pas commandée actuellement à cette limite est sélectionné.

7. Circuit selon la revendication 6,
caractérisé par le fait qu'un signal de données (DATAIN) est envoyé comme signal de commande à une entrée du comparateur de phase du régulateur de phase sélectionné et que le signal délivré en sortie par la ligne à retard de ce régulateur de phase forme le signal d'horloge associé au signal de données.

8. Circuit selon la revendication 6,
caractérisé par le fait que le signal d'état de remplissage d'une mémoire tampon est envoyé comme signal de commande à l'entrée de filtre de boucle du régulateur de phase sélectionné et que le signal délivré à la sortie de ce régulateur de phase forme le signal d'horloge pour lire la mémoire tampon.

9. Circuit selon l'une des revendications 6 à 8,
caractérisé par un régulateur de phase actuellement non sélectionné qui est tenu prêt dans l'état verrouillé d'une commande sur l'autre côté respectif, par rapport au milieu de la gamme de réglage, à l'opposé du régulateur de phase actuellement sélectionné.

10. Circuit selon l'une des revendications 6 à 9,
caractérisé par des régulateurs de phases divisés en deux groupes, un des deux signaux d'horloge de référence (CREF H, CREF_L) complémentaires étant envoyé aux lignes à retard de chaque groupe de régulateurs de phases.

11. Circuit selon l'une des revendications 5 à 9,
caractérisé par le fait qu'un signal d'horloge présent localement pour l'émission d'un flux de données est envoyé au circuit comme signal d'horloge de référence.
